# EUROPEAN PATENT APPLICATION

(11) **EP 4 597 177 A1**
(43) Date of publication of application: **06.08.2025**
(21) Application number: 25155054.7
(22) Date of filing: 30.01.2025
(51) Int. Cl.: G02B 3/08, H10F 77/42

(54) **PHOTOVOLTAIC UNIT FOR MAKING A SUNSHADE PANEL, AND SUNSHADE PANEL PROVIDED WITH SUCH PHOTOVOLTAIC UNIT**

(30) Priority: 02.02.2024 IT 202400002226
(71) Applicant: DOTT. GALLINA S.r.l., 10129 Torino (IT)
(72) Inventor: PALAZZETTI, Mario, 10129 TORINO (IT); GALLINA, Dario, 10129 TORINO (IT)
(74) Representative: Studio Torta S.p.A.

(57) **Abstract**

A photovoltaic unit (10), for making a photovoltaic sunshade panel (1), has a support element (21), which extends along a longitudinal axis (11), supports photovoltaic cells (20) and is connected by two side walls (24) to a transparent profile (15), arranged in front of the photovoltaic cells (20); the transparent profile (15) is parallel to the longitudinal axis (11) and has cross-sections with constant shape and dimensions along such longitudinal axis (11), when cross-sectioned with orthogonal cross-section planes; the cross-sections of the transparent profile (15) define a lens configured so as to direct and concentrate light rays towards the area (F) in which the photovoltaic cells (20) are arranged.

## Description

### Cross-reference to related applications

This patent application claims priority from Italian patent application no. 102024000002226 filed on February 2, 2024, the entire disclosure of which is incorporated herein by reference.

### Technical field

The present invention relates to a photovoltaic unit defining a module for making a photovoltaic sunshade panel.

### Background

As is known, sunshade panels are elements provided with strips that are parallel to one another and intercept sunlight, so that it does not impinge upon objects or people located behind such panel. At the same time, gaps provided between the strips may allow a part of the sunlight to pass through, in particular as scattered or reflected sunlight, which poses problems if intercepted, as this could compromise the correct illumination of the rooms.

Generally, sunshade panels are used externally to and in front of the windows of buildings although they can also have other fields of use.

Recently, some developments to integrate photovoltaic cells in sunshade panels of conventional type have been made, in order to convert the light energy from the sun rays into electrical energy. Within sunshade panels of this type, there is the need to adopt measures that allow prior art solutions to be improved, in particular that allow the component manufacturing and assembly to be simplified, and/or solar energy capture to be optimised, thereby improving efficiency, and/or a relatively compact solution to be obtained.

Furthermore, there is the need to prevent interference with the scattered component of sunlight.

Finally, there is the need to be able to provide particular aesthetic aspects, which may be appreciated by the users.

The object of the present invention is to fulfil the aforesaid needs, preferably in a simple and inexpensive way.

### Summary

According to the present invention, there is provided a photovoltaic unit for a sunshade panel, as defined in claim 1.

Moreover, according to the present invention, a photovoltaic sunshade panel is provided, having such photovoltaic unit, according to claim 14.

Moreover, the dependent claims indicate preferred embodiments according to the invention.

### Brief description of the drawings

For a better understanding of the present invention, some embodiments shall now be described, purely by way of nonlimiting example, with reference to the accompanying drawings, wherein:
- Fig. 1 is a schematic plan view of a photovoltaic sunshade panel, provided with a plurality of photovoltaic units according to a preferred embodiment of the present invention;
- Figs. 2 and 3 are cross-sections obtained, respectively, according to cross-sectional planes identified by the lines II-II and III-III of Fig. 1, and show in an enlarged scale some details of one of the photovoltaic units of Fig. 1;
- Fig. 4 illustrates, schematically and in side view, a photovoltaic sunshade panel according to a variant of Fig. 1; and
- Fig. 5 is analogous to Fig. 3 and illustrates a further preferred embodiment of the photovoltaic unit according to the present invention.

### Description of preferred embodiments

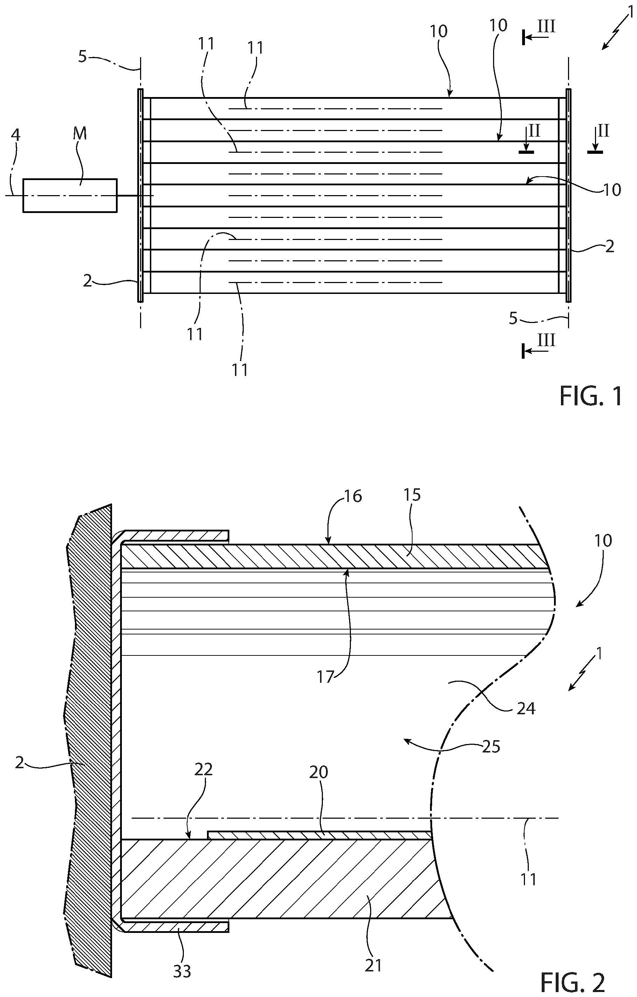

In Fig. 1, the reference 1 indicates, as a whole, a photovoltaic sunshade panel, illustrated schematically.

The panel 1 comprises two heads 2, which are spaced from each other along an axis 4 and extend along respective axes 5 transverse to the axis 4. In particular, the axes 5 are straight and parallel to one another. The heads 2 define a frame supporting a plurality of photovoltaic units 10, identical to one another as regards shape, structure and dimensions, so that, in practice, they define a series of identical modules interchangeable with one another. Preferably, the modules defined by the photovoltaic units 10 are arranged side by side, without gaps, to prevent the loss of direct solar radiation that can be used by photovoltaic cells. In fact, as will be described in more detail below, such direct solar radiation is concentrated to subsequently generate electrical energy.

The photovoltaic units 10 extend along respective axes 11 parallel to one another and to the axis 4, and are preferably coplanar to one another.

In the example illustrated in Fig. 1, the frame defined by the heads 2 is hinged to a further support frame, fixed and not shown, so as to be able to rotate about the axis 4 under the action of a motor M, in order to orient the panel 1, and consequently its photovoltaic units 10, with respect to the position of the sun.

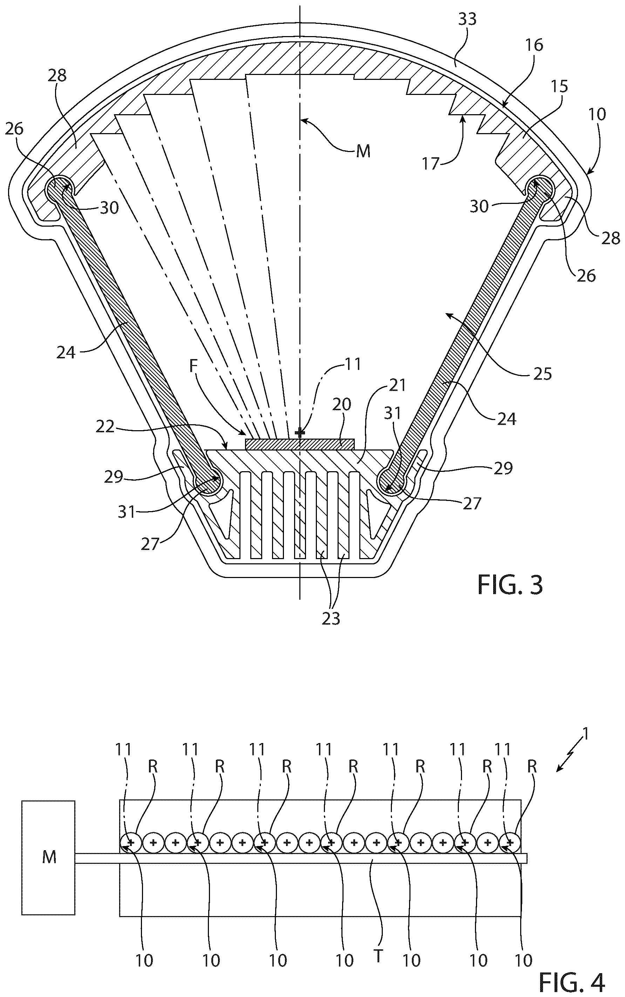

The following description will refer to a single photovoltaic unit 10, according to what is illustrated in cross-section in Figs. 2 and 3.

The photovoltaic unit 10 comprises a transparent profile 15, extending along the axis 11 and, preferably, is made of a plastic material. The transparent profile 15 has a cross-section (obtained orthogonally to the axis 11) with constant shape and dimensions for the whole of the axial length of such transparent profile 15. The latter is relatively thin and is defined by an outer surface 16 and by an inner surface 17, opposite each other. Preferably, the transparent profile 15 is defined by an extruded element, made of polycarbonate. However, other transparent materials can be used, alternatively to polycarbonate.

According to an aspect of the present invention, the cross-section of the transparent profile 15 (obtained by cross-section planes orthogonal to the axis 11) defines a lens, preferably a Fresnel lens, so as to direct and concentrate the sunlight, which impinges upon the outer surface 16 (and which passes through the transparent material of said transparent profile 15), towards an area F (Fig. 3) also extending along the axis 11.

In a particular configuration of the present invention, the outer surface 16 is convex, by way of example with a circular cylindrical shape, while the inner surface 17 is defined by a set of flat faces that are parallel to the axis 11 and define, in cross-section, a broken line.

The photovoltaic unit 10 further comprises one or more photovoltaic cells 20 arranged along a strip in the area F in front of the inner surface 17 of the transparent profile 15, so as to capture the concentrated solar energy, and then convert it into electrical energy in a way that is known and not described in detail. The photovoltaic cells 20 are arranged, by way of example, with a strip shape, onto a support element 21 extending along the axis 11 and made of a thermally conductive material.

With reference to Fig. 2, the support element 21 has the same length as the transparent profile 15. In particular, the photovoltaic cells 20 are arranged for the whole of the length of the support element 21 (possibly with the exception of the axial ends of the support element 21, based on what is visible in Fig. 2).

Preferably, the support element 21 has a cross-section (obtained orthogonally to the axis 11) with constant shape and dimensions for the whole of the axial length of such support element 21. More preferably, the support element 21 is defined by a profile made of aluminium, or another metallic material, configured so as to dissipate the heat of the photovoltaic cells 20. In the specific example illustrated, with reference to Fig. 3, the support element 21 comprises: a face 22, facing towards the surface 17 and supporting the photovoltaic cells 20; and a plurality of fins 23, arranged on the opposite side with respect to the face 22 and projecting in positions spaced from one another so as to allow air to enter and circulate.

The transparent profile 15 is connected in a fixed position to the support element 21 by two side walls 24, arranged on opposite sides of the area F and extending for the whole of the length of the transparent profile 15 and of the support element 21, so as to delimit, together with these two components, a cavity 25 housing the photovoltaic cells 20. At the same time, the fins 23 are outside the cavity 25.

In particular, the side walls 24 comprise respective ends 26 and 27, opposite each other, of which the ends 26 are connected to respective edges 28 of the transparent profile 15, while the ends 27 are connected to respective side portions 29 of the support element 21. The system connecting the ends 26 and 27 to the transparent profile 15 and to the support element 21 is selected so as to ensure stable fixing of the components. This connection system is defined by male-female couplings, by way of example: more in detail, the ends 26 and 27 engage respective seats 30 and 31, obtained respectively in the edges 28 and in the side portions 29.

Coupling of the ends 26 and 27 in the respective seats 30 and 31 takes place during assembly of the photovoltaic unit 10, by way of example by sliding in a direction parallel to the axis 11 with respect to the transparent profile 15 and to the support element 21.

The side walls 24 are preferably made of transparent material, so that, during use, reflected and/or scattered light passes through the side walls 24, from the cavity 25 outwards.

In particular, the side walls 24 are convergent, from the transparent profile 15 towards the support element 21. In other words, the distance between the ends 26 is greater than the distance between the ends 27.

According to a preferred and important aspect of the present invention, the angle of the side walls 24 and the configuration of the lens defined by the transparent profile 15 are such that the light exiting from such lens does not impinge directly on the side walls 24. In other words, the direct component of sunlight emitted from the surface 17 of the lens (and which can contain around 80% of the energy) is completely directed towards the photovoltaic cells 20: in fact, the side walls 24 are parallel (or divergent) with respect to the direction of the light emitted from the ends 28 of the lens into the cavity 25. Therefore, the side walls 24 only transmit scattered light towards the outside of the photovoltaic unit 10. The opaque parts (in particular the photovoltaic cells 20) are so small that they have a negligible interference with the scattered sunlight transmitted by the photovoltaic unit 10 (regardless of the fact that the various photovoltaic units 10 are placed side by side without leaving any gaps in the panel 1). At the same time, the solar energy directed on the photovoltaic cells 20 is maximised.

As it is evident from Fig. 3, the photovoltaic unit 10 preferably has an arrangement of components and a shape symmetrical with respect to an ideal median plane M on which the axis 11 lies. In particular, the lens defined by the transparent profile 15 is a cylindrical lens, i.e., is symmetrical with respect to the plane M.

With reference to Fig. 2, for each of the two axial ends, the photovoltaic unit 10 comprises a respective cover 33, which axially closes the cavity 25. Preferably, the cover 33 is coupled at the axial end of the transparent profile 15 and of the support element 21 so as to ensure fluid-tightness in the cavity 25, by way of example by gaskets, not shown. In the specific example shown in Fig. 2, the cover 33 is defined by a cap fitted around the axial end of the transparent profile 15 and of the support element 21.

The covers 33 are secured to the heads 2 during mounting to assemble the panel 1, by known coupling techniques, not described in detail (by way of example, by gluing, by interlocking, by snap coupling, etc.). At least one of the covers 33 for each photovoltaic unit 10 and at least one of the heads 2 have characteristics such as to allow the wiring to pass through to supply the electric current generated by the photovoltaic cells 20, according to methods that are not shown, but in any case known based on the common knowledge of a person skilled in the art.

According to an embodiment, not shown, the covers 33 are defined directly by respective portions of the heads 2. In other words, the heads 2 and the covers 33 are not distinct bodies secured to one another, as in Fig. 2, but define parts of a same body, in a single piece. Therefore, in this case, the photovoltaic unit 10 is effectively without covers at its axial ends (and hence the cavity 25 is then only closed during mounting on the frame made of the two heads 2).

In the variant schematized in Fig. 4, the photovoltaic units 10 are not fixed to the heads 2, but are pivoted thereto in a manner not shown in detail, to be able to rotate about the respective axes 11, to adjust their inclination with respect to the position of the sun, alternatively to the adjustment method shown in Fig. 1. In particular, the cylindrical shape of the surface 16 has an axis that coincides with the hinge axis (11), so that coupling of the photovoltaic units to the heads 2 is simple.

In Fig. 4, the motor M is connected to all the photovoltaic units 10 by a transmission element T, which causes the simultaneous rotation of the photovoltaic units 10 and, by way of example, is defined by a worm screw, meshing with gear wheels R, coaxial and fixed in relation to the respective photovoltaic units 10. According to an alternative, not shown, each photovoltaic unit 10 can be moved by a respective electric motor, independently from the others.

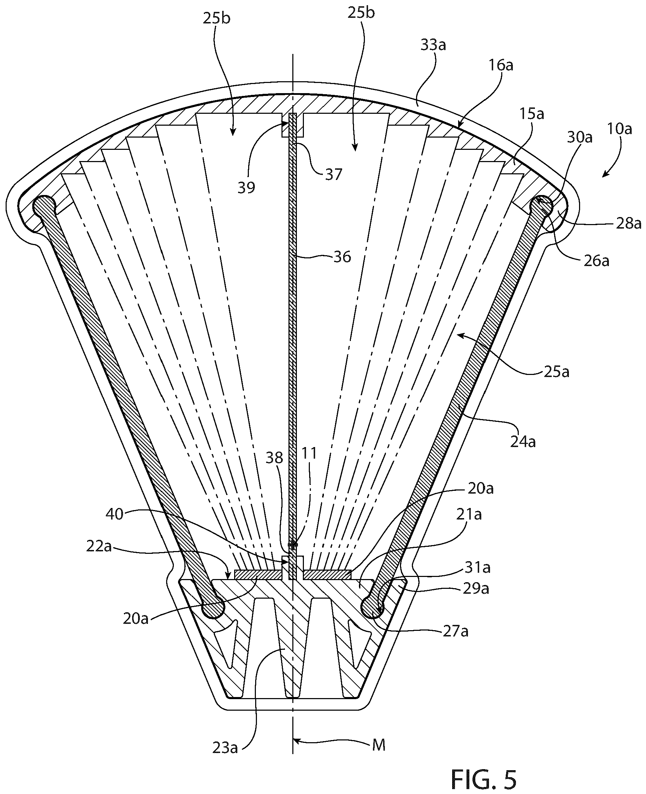

The embodiment of Fig. 5 relates to a photovoltaic unit 10a, the constituent parts of which are indicated, where possible, with the same reference numbers used in Fig. 3, but followed by the reference letter "a".

The photovoltaic unit 10a differs from the photovoltaic unit 10 in that the cavity 25a houses a sheet or foil 36, preferably having a flat shape and being arranged along the plane of symmetry M of the lens defined by the transparent profile 15a. The sheet 36 preferably has a predefined surface colour and/or pattern, and its colour or pattern is perceived visually by the users from the outside of the photovoltaic unit 10a. This configuration allows the aesthetics of the photovoltaic unit 10a to be adapted and varied based on the demands of users, in a relatively simple way, without any loss in producing electrical energy, as the sheet 36 is arranged in such a way that it does not interfere with the direct component of sunlight, emitted from the surfaces 17, while it interferes only with the scattered component of light, which passes through the side walls 24 and is then perceived on the outside.

Moreover, the sheet 36 performs a structural function (i.e., it defines a sort of inner shell or core that stiffens the photovoltaic unit 10a, by coupling the transparent profile 15a to the support element 21a), and can have features of heat transmission such as to perform a dissipator function, which may also allow elimination of the fins 23, with consequent advantages in terms of overall dimensions.

From the above, it is evident how the construction features of the photovoltaic unit 10, 10a are very simple and, thanks to the lens defined by the transparent profile 15, 15a, allow sunlight to be focused on the photovoltaic cells 20, 20a, thereby improving their performance in terms of electrical power per unit area. In particular, the transparent profile 15, 15a is very simple to manufacture and to mount, as it has a constant cross-section and is preferably defined by an extruded plastic material.

At the same time, as explained in detail above, the side walls 24 transmit the scattered component of light towards the outside, without compromising the production of electrical energy. In buildings, thanks to the transmission of scattered light, the panel 1 does not completely obscure rooms, as instead sometimes occurs with sunshades of known type. In practice, the panel 1 allows rooms to receive the same amount of light that would be received by a north-facing window without a sunshade (in the northern hemisphere of the Earth) It is also possible to advantageously use the panel 1 also in agriculture, in place of common solar panels, as it allows the scattered component of light to reach the crops. In particular, in solutions with conventional solar panels, these panels must be spaced from one another to allow light to pass through, resulting in a loss of photovoltaic power, while, in the proposed solution, solar energy capture is maximised.

Moreover, the components are relatively simple to assemble, by way of example thanks to the male-female couplings provided at the ends 26, 26a and/or 27, 27a.

Assembly of the panel 1 is also relatively simple, using photovoltaic units 10, 10a which are, in practice, modular.

Moreover, the photovoltaic unit 10a allows aesthetic effects, by way of example colour effects, to be obtained simply by providing the sheet 36 inside it, without loss of electrical energy production. In fact, as explained above, such sheet, arranged along the plane of symmetry M, does not interfere with the direct sunlight that converges on the photovoltaic cells 20, while defining the colour of the panel 1 perceived from the outside. Furthermore, in agriculture, this property offers the chance to use specific colours, by way of example fluorescent, in spectral bands that tend to stimulate crops, to increase crop production efficiency.

Other advantages are also evident to a person skilled in the art based on the description provided above by way of example.

Finally, it is clear that modifications and variations can be made to the photovoltaic unit 10, 10a and to the panel 1 described above with reference to the accompanying figures, without departing from the scope of protection of the present invention, as defined in the appended claims.

By way of example, rotation of the panel 1 about the axis 4 (Fig. 1), and/or rotation of the photovoltaic units 10, 10a about the respective axes 11 (Fig. 4), could be manually operated, possibly by a mechanical transmission, instead of being operated by electric motors.

## Claims

1. Photovoltaic unit (10;10a) for making a photovoltaic sunshade panel (1), the photovoltaic unit comprising:
• a support element (21;21a), extending along a longitudinal axis (11);
• photovoltaic cells (20;20a) supported by said support element (21;21a) in an area (F) that extends along said longitudinal axis (11);
**characterised by** further comprising:
• a transparent profile (15;15a), arranged in front of said photovoltaic cells (20;20a), extending parallel to said longitudinal axis (11) and having cross-sections with constant shape and dimensions along said longitudinal axis (11), when cross-sectioned with cross-section planes orthogonal to said longitudinal axis (11); and
• two side walls (24;24a), which connect respective edges (28;28a) of said transparent profile (15;15a) to said support element (21;21a) and delimit, together with said transparent profile (15;15a) and said support element (21;21a), a cavity (25;25a) housing said photovoltaic cells (20; 20a) ;
and wherein the cross-sections of said transparent profile (15;15a) define a lens configured so as to direct and concentrate light rays towards said area (F).

2. The photovoltaic unit according to any one of the preceding claims, wherein said side walls (24;24a) are transparent.

3. The photovoltaic unit according to claim 2, wherein said side walls (24) and said lens have a configuration such that concentrated light exiting from said lens does not directly impinge upon said side walls (24).

4. The photovoltaic unit according to claim 2 or 3, wherein said cavity (25a) houses a sheet or foil (36), preferably coloured.

5. The photovoltaic unit according to claim 4, wherein said lens is symmetrical with respect to an ideal median plane (M) on which said longitudinal axis (11) lies, and said sheet or foil (36) has a flat shape and is arranged along said ideal median plane (M).

6. The photovoltaic unit according to any one of the preceding claims, wherein said side walls (24;24a) are defined by pieces that are distinct from said support element (21;21a) and from said transparent profile (15;15a) and are coupled to said support element (21;21a) and transparent profile (15;15a) by male-female couplings.

7. The photovoltaic unit according to any one of the preceding claims, wherein said lens is a Fresnel lens.

8. The photovoltaic unit according to any one of the preceding claims, wherein said cavity (25;25a) is axially closed by two covers (33;33a) fixed at axial ends of said transparent profile (15;15a) and of said support element (21;21a).

9. The photovoltaic unit according to claim 8, wherein said covers (33;33a) are defined by caps fitted around said axial ends.

10. Photovoltaic sunshade panel (1) comprising a frame consisting of two heads (2), and a plurality of photovoltaic units (10;10a), which are made according to any one of the preceding claims and are supported by said heads (2).

11. The photovoltaic sunshade panel according to claim 10, wherein the side walls (24;24a) of the photovoltaic units are transparent and the photovoltaic units (10;10a) are arranged side by side without gaps.

12. The photovoltaic sunshade panel according to claim 10 or 11, wherein said photovoltaic units (10;10a) are pivoted at said heads (2) so as to rotate about the respective longitudinal axes (11).
